# EUROPEAN PATENT APPLICATION

(11) **EP 4 498 763 A1**
(43) Date of publication of application: **29.01.2025**
(21) Application number: 23306286.8
(22) Date of filing: 25.07.2023
(51) Int. Cl.: H05K 1/02, H05K 1/16, H05K 3/46

(54) **A METHOD FOR MANUFACTURING A PRINTED CIRCUIT BOARD EMBEDDING A COOLING CAVITY**

(71) Applicant: Mitsubishi Electric R&D Centre Europe B.V., 1119 NS Schiphol Rijk Amsterdam (NL); MITSUBISHI ELECTRIC CORPORATION, Chiyoda-ku Tokyo 100-8310 (JP)
(72) Inventor: LEFEVRE, Guillaume, 35708 RENNES Cedex 7 (FR); MORAND, Julien, 35708 RENNES Cedex 7 (FR)
(74) Representative: Cabinet Le Guen Maillet

(57) **Abstract**

The present invention concerns a method for manufacturing a printed circuit board embedding a cooling cavity. The method comprises the steps of:
- machining a part of a soluble preg material 400 in order to form a pattern 410a-410g,
- plating 420 the formed pattern,
- filling the plated formed pattern with an electrically insulating material 430a-430g,
- removing the remaining soluble preg material 400 with a solvent.

## Description

### TECHNICAL FIELD

The present invention relates generally to a method for manufacturing a printed circuit board embedding a cooling cavity.

### RELATED ART

Printed circuit boards (PCB) embedding windings intrinsically demonstrate clear advantages such as low profile, ease of manufacturability, repeatability of electrical parameters and improved thermal performances.

They may be used in planar magnetics components, like for example transformers and inductors. Despite this, planar magnetics components are systematically restricted to niche markets in the low to moderate power ranges. With the advent of Wide Band Gap devices (WBG) such as Silicon Carbide (SiC) or Gallium Nitride (GaN), the current power converters operate at much higher switching frequencies compared to their Silicon counterpart. The constraints on magnetics are consequently mitigated, opening for PCB based planar the field to higher power levels.

Due to their systematic use in high density systems, effective thermal management is a challenging task. In high power applications, liquid cooling is mostly used. However, conventional cold plates can only cool down from external sides of the devices, i.e. the magnetic materials. This results in a poor heat extraction from the core of the system (i.e. copper windings) which becomes the limiting factor in the design. Indeed, further increase in the power density would imply to increase the current density, resulting in higher losses with limited cooling area. For mitigation purpose, it is conventionally recommended to connect the windings to the cold plate through copper blocks insulated with thermal interface materials.

The main challenge is to cool down PCB windings at the closest to reduce hot spots as much as possible. On the other hand, the cooling system must be selected to avoid adding excessive losses that could emerge from locating a metallic part in the vicinity of an AC magnetic field (eddy currents). Finally, the electric insulation of the cooling device is a critical point for safety of persons. From a manufacturing point of view, the strength of PCB based windings is the cost effectiveness and the high repeatability in dimensions.

### SUMMARY OF THE INVENTION

The present invention aims to provide a method and a system which provide an efficient cooling system for windings intended to be used in magnetic components.

To that end, the present invention concerns a method for manufacturing a printed circuit board composed of non soluble conventional preg material part and soluble preg material part, characterized in that the method comprises the steps of:
- machining a part of the soluble preg material in order to form a pattern,
- plating the formed pattern,
- filling the platted formed pattern with an electrically insulating material,
- removing the remaining soluble material with a solvent.

The present invention concerns also a system for manufacturing a printed circuit board composed of non soluble conventional preg material part and soluble preg material part, characterized in that the system comprises:
- means for machining a part of the soluble preg material in order to form a pattern,
- means for plating the formed pattern,
- means for filling the platted formed pattern with an electrically insulating material,
- means for removing the remaining soluble material with a solvent.

Thus, the plated formed pattern can be used as a heat management system with a fluid or gaz flowing inside to cool down the printed circuit board. Since the cooling system is embedded into the PCB, the heat management is significantly improved due to a reduced number of thermal interfaces when compared to conventional techniques. The plated formed pattern can be also used to carry an electrical current. In such a case, the coolant has to be wisely chosen with regards to the dielectric properties since the potential of the formed pattern is applied to the coolant. Since the device is able to carry current, it can be advantageously used in a magnetic component such an inductor or a transformer.

According to a particular feature, the method further comprises the steps, prior removing the remaining soluble material with the solvent, of:
- machining another part of the soluble preg material in order to form another pattern,
- plating the other formed pattern,
- filling the other platted formed pattern with an electrically conductive material.

Thus, electrical formed patterns filled with electrically conductive materials used for carrying current and cooling parts are no longer in contact. Since the insulation is ensured by the electrically insulating material between the patterns, no specific attention must be paid to the coolant with respect to its dielectric abilities or ionization risks. In case of using conductive fluids, the hydraulic circuit must not have to be electrically insulated. Current carrying capabilities remain possible.

According to a particular feature, the method further comprises the steps of:
- laminating the obtained printed circuit board,
- inserting the laminated obtained printed circuit board in a magnetic component.

Thus, the obtained circuit board can be used for cooling purpose only but also as a set of windings carrying current and consequently magnetizing the magnetic component.

According to a particular feature, the method further comprises the step, executed prior inserting the laminated obtained printed circuit board in the magnetic component, of etching chemically and/or drilling the lamination to make an electrical connection.

According to a particular feature, the laminated obtained printed circuit board is inserted between primary winding's conductors and the secondary winding's conductors of a transformer.

Thus, the cooling system is located in the middle in the transformer and prevents the system from hot spots normally located in this area.

According to a particular feature, a first laminated obtained printed circuit board is inserted at the top of primary windings and a second laminated obtained printed circuit board is inserted at the bottom of secondary windings of a transformer.

Thus, the cooling system can both cool down the primary windings with the core part on the top side and the secondary windings with the core part on the bottom side. In addition to that, this arrangement helps reduce eddy losses into the laminated obtained printed circuit board since located the near-zero field area.

According to a particular feature, two laminated obtained printed circuit boards are inserted in the magnetic component which is a transformer, one laminated obtained printed circuit board acting as a primary winding and one laminated obtained printed circuit board acting as a secondary winding of the transformer.

Thus, the heat extraction is directly done inside the windings for optimal results.

### BRIEF DESCRIPTION OF THE DRAWINGS

The characteristics of the invention will emerge more clearly from a reading of the following description of example embodiments, the said description being produced with reference to the accompanying drawings, among which:
Fig. 1a represents a first example of an algorithm for manufacturing a printed circuit board embedding a cooling cavity according to the present invention that may be used in a magnetic component;
Fig. 1b represents a second example of an algorithm for manufacturing a printed circuit board embedding a cooling cavity according to the present invention that may be used in a magnetic component;
Fig. 2 represents an example of an architecture of a device for manufacturing a printed circuit board embedding a cooling cavity according to the present invention that may be used in a magnetic component;
Fig. 3 represents an example of a printed circuit board embedding a cooling cavity according to the present invention;
Figs. 4a to 4h represent an example of the different steps for manufacturing a printed circuit board embedding a cooling cavity according to the present invention;
Figs. 5a to 5h represent an example of the different steps for manufacturing a printed circuit board embedding a cooling cavity according to the present invention;
Figs. 6a to 6f represent an example of the different steps for manufacturing a printed circuit board embedding a cooling cavity according to the present invention;
Fig. 7 represents an example of a magnetic component comprising a printed circuit board embedding a cooling cavity according to the present invention;
Fig. 8 represents an example of a magnetic component comprising a printed circuit board embedding a cooling cavity according to the present invention;
Fig. 9 represents an example of a magnetic component comprising a printed circuit board embedding a cooling cavity according to the present invention.

### DESCRIPTION

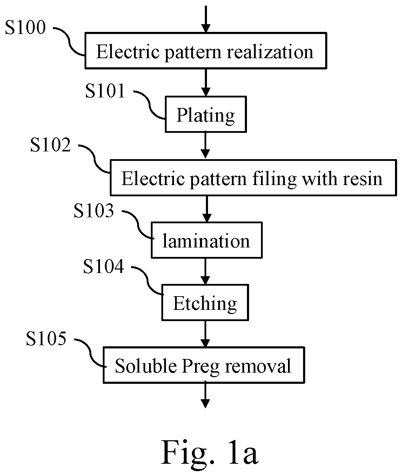

**Fig. 1a** represents a first example of an algorithm for manufacturing a printed circuit board embedding a cooling cavity according to the present invention that may be used in a magnetic component.

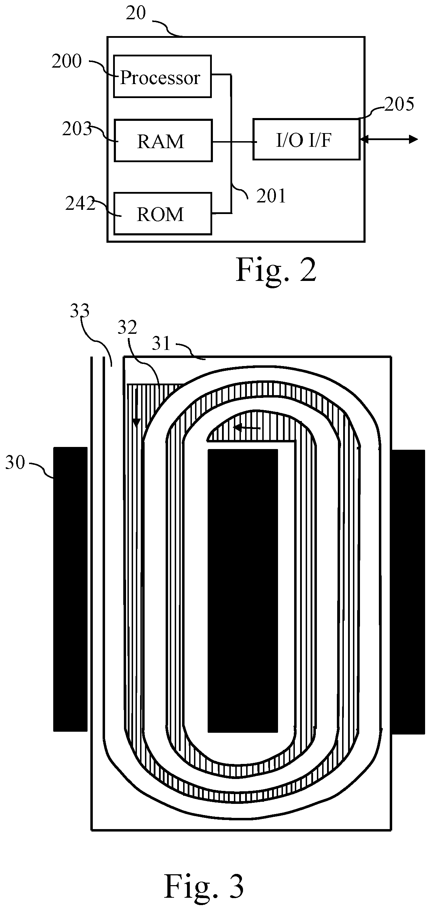

The present algorithm is executed by a device 20 for manufacturing a printed circuit board embedding a cooling cavity according to the present invention that may be used in a magnetic component that will be disclosed hereinafter in reference to Fig. 2.

The present invention uses subtractive manufacturing applied to PCB technology. To achieve this goal, a conventional pre preg material is locally replaced by a special soluble preg material with a liquid or solvent. The conventional preg material is a material that is not soluble. The soluble preg material is, for example, Polyvinyl alcohol, Butenediol Vinyl Alcohol Co-polymer or inorganic salts in a compressed form. The solvent may be water.

PCB PP (Prepreg), or Pre-preg, is a shorthand expression for Pre-Impregnated, also referred to Preg, which is composed of fiberglass fabric impregnated with resin. The resin has been partially cured but not hardened during the Prepreg coating operation. When heating the PCB pressing process, the resin in Prepreg flows, sticks and bonds the PCB core with copper foil or other materials.

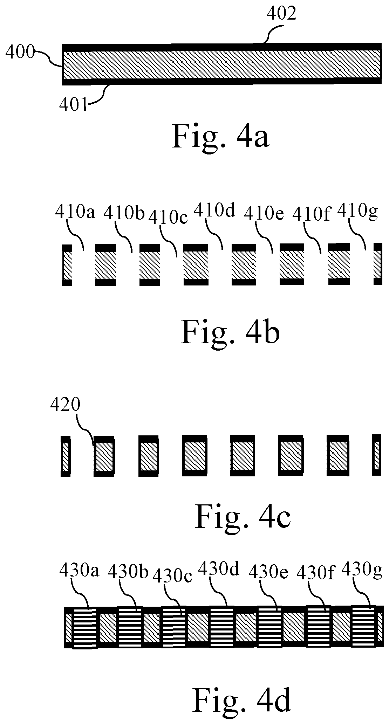

An example of a component embedding a cooling cavity is given in Fig. 4a.

In Fig. 4a, a PCB is composed of a soluble preg material 400 and two layers of copper 401 and 402.

A step S100, the device 20 commands the realization of electric pattern of the magnetic component embedding a cooling cavity.

The substrate is basically drilled or milled in order to form mechanical vias or microvias or patterns according to the thickness of the substrate.

An example is given in Fig. 4b.

In Fig. 4b, apertures 410a to 410g are realized in the PCB composed of the soluble preg material 400 and two layers of copper 401 and 402.

At step S101, the device 20 commands the plating of the apertures 410a to 410g with for example copper.

An example is given in Fig. 4c which shows the copper plating 420 of the apertures.

At step S102, the device 20 commands the filling of the apertures with an electrically insulating material like for example resin. The resin is for example TAIYO THP-100 DX1 proposed by the company TAIYO AMERICA^{™} or resin provided by the company Micromax^{™} *CB100.*

An example is given in Fig. 4d which shows the filing 430a to 430g of the apertures by resin.

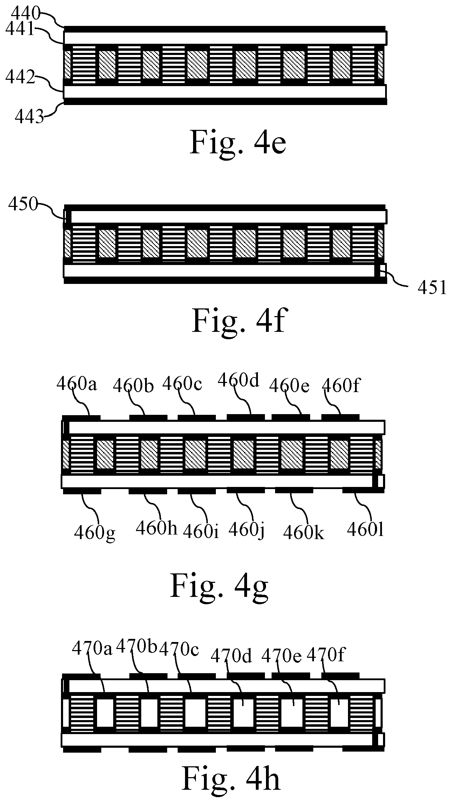

At step S103, the PCB obtained at step S102 is laminated in order to obtain a PCB as shown in Fig. 4e.

The Fig. 4e shows the PCB obtained at step S102 on the top of which a layer of conventional pre preg material 441 and a copper layer 440 are laminated and on the bottom of which a layer of conventional pre preg material 442 and a copper layer 443 are laminated.

At step S104, the copper layers are respectively electrically connected by vias 450 and 451 shown in Fig. 4f to one of the plating layer made at step S101 and the copper layers are etched in order to form an inductive component composed of the conducting patterns 460a to 4601 as shown in Fig. 4g.

At step S105, the soluble prepeg is removed using a solvent.

As a result, the plated apertures 470a to 470f shown in Fig. 4h and the conducting patterns 460a to 4601 form an inductor.

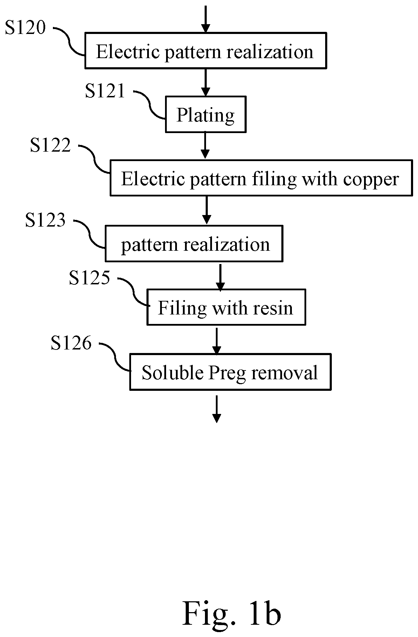

**Fig. 1b** represents a second example of an algorithm for manufacturing a printed circuit board embedding a cooling cavity according to the present invention that may be used in a magnetic component.

The present algorithm is executed by a device 20 for manufacturing a printed circuit board embedding a cooling cavity according to the present invention that may be used in a magnetic component that will be disclosed hereinafter in reference to Fig. 2.

The present invention uses subtractive manufacturing applied to PCB technology. To achieve this goal, a conventional pre preg material is locally replaced by a special soluble preg material with a liquid or solvent.

Preferably, the soluble material is soluble into the cooling liquid material which will be used, at least partially, during cooling. For example, the cooling liquid material is water. For example, the soluble material is Polyvinyl alcohol (PVA) which can stand a lamination temperature. For example, the soluble material is Butenediol Vinyl Alcohol Co-polymer. For example, the soluble material is inorganic salts like for example NaCl in a compressed form.

PCB PP (Prepreg), or Pre-preg, is a shorthand expression for Pre-Impregnated, also referred to Preg, which is composited of fiberglass fabric impregnated with resin. The resin has been partially cured but not hardened during the Prepreg coating operation. When heating the PCB pressing process, the resin in Prepreg flows, sticks and bonds the PCB core with copper foil or other materials.

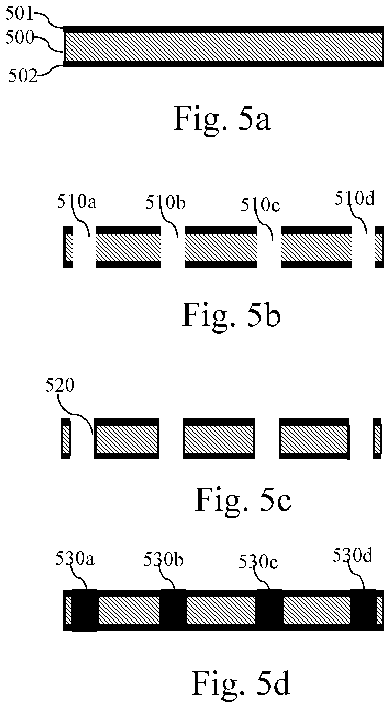

An example is given in Fig. 5a.

In Fig. 5a, a PCB is composed of a soluble preg material 500 and two layers of copper 501 and 502.

A step S120, the device 20 commands the realization of electric pattern of the magnetic component embedding a cooling cavity.

The substrate is basically drilled or milled with mechanical vias or microvias or patterns according to the thickness of the substrate.

An example is given in Fig. 5b.

In Fig. 5b, apertures 510a to 510d are realized in the PCB composed of the soluble preg material 500 and two layers of copper 501 and 502.

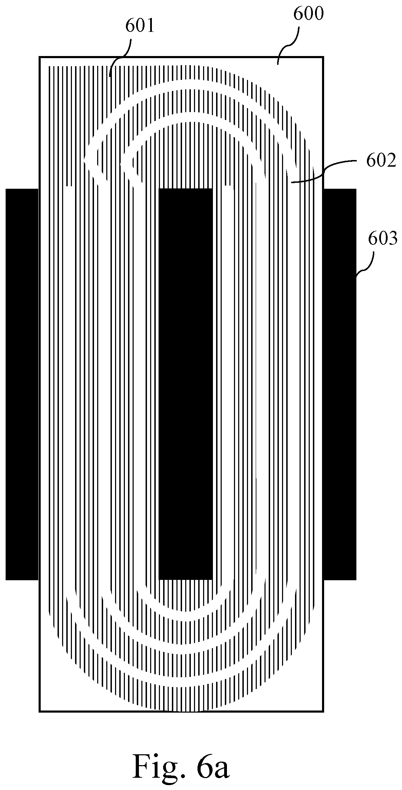

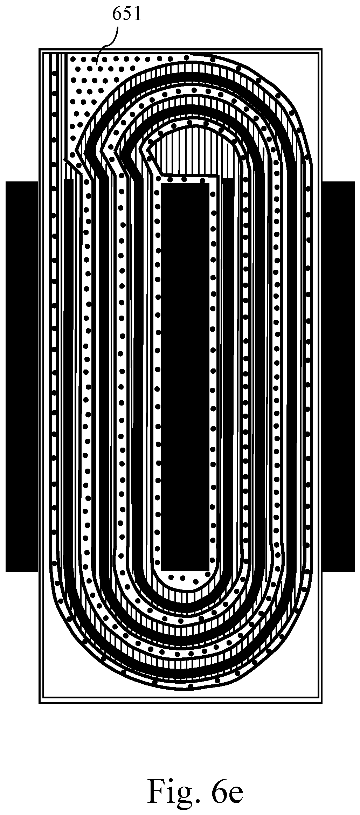

Another example is given in Fig. 6a.

In Fig. 6a, a conventional pre preg material 600 is locally replaced by a special soluble preg material 601.

The soluble preg material 601 is milled in order to form three cavities 602.

The PCB is intended to be placed in a magnetic core 603.

At step S121, the device 20 commands the plating of the apertures 510a to 510d or the milled pattern 602 with for example copper.

An example is given in Fig. 5c which shows the copper plating 520 of the apertures.

At step S122, the device 20 commands the filling of the apertures with an electrically conducting material like for example copper. An example is given in Fig. 5d which shows the filling 530a to 530c of the apertures by copper.

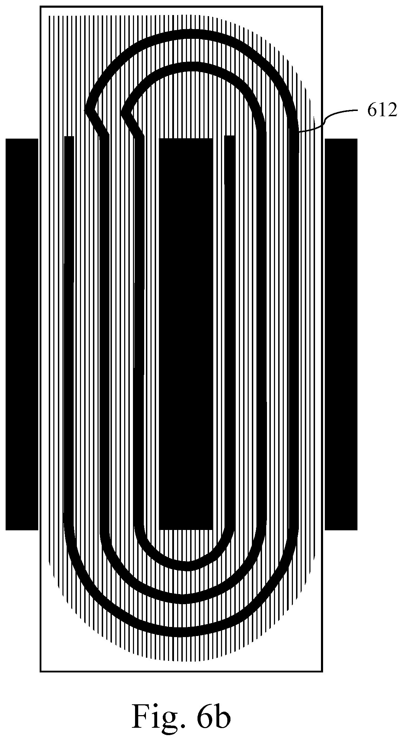

Another example is given in Fig. 6b which shows the milled pattern 612 that is copper plated and filed by copper.

A step S123, the device 20 commands the drilling and/or milling of the printed circuit board.

The substrate is basically drilled or milled with mechanical vias or microvias or patterns according to the thickness of the substrate.

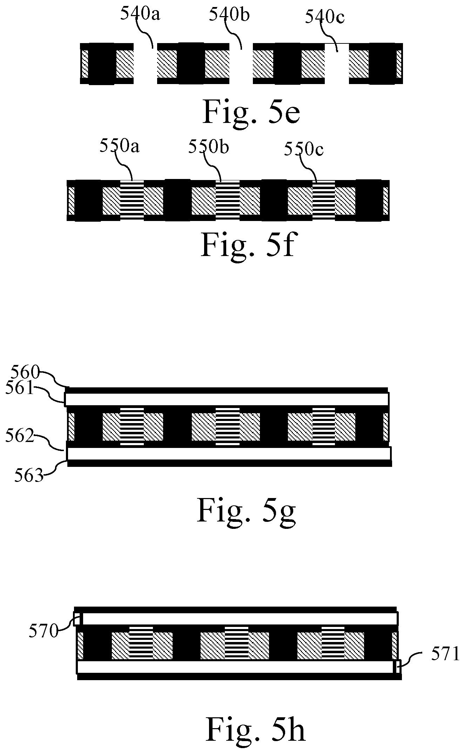

An example is given in Fig. 5e.

In Fig. 5e, apertures 540a to 540c are realized in the PCB composed of the soluble preg material 500 and two layers of copper 501 and 502.

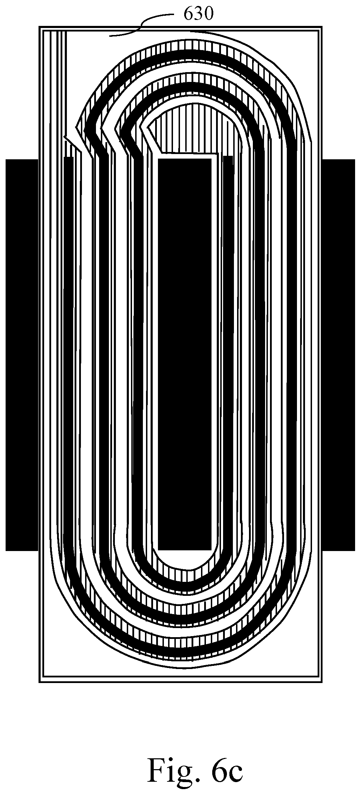

Another example is given in Fig. 6c wherein the soluble preg is milled in order to form cavities 630 separating the filed windings.

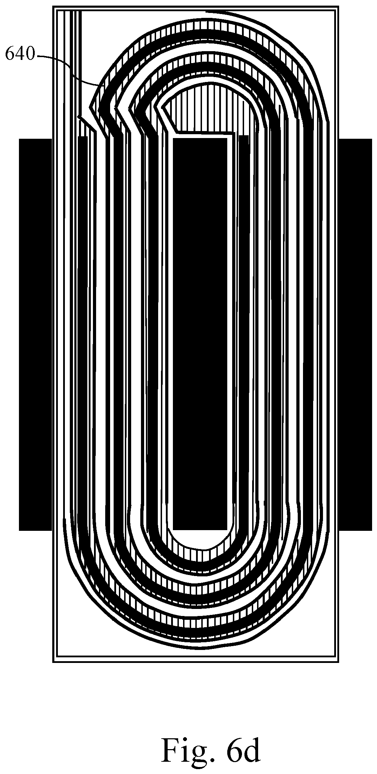

At the same step, the cavities 630 are electroless plated in order to form electroless plated cavities 640 as shown in Fig. 6d.

At step S125, the device 20 commands the filling of the apertures made at step S123 with an electrically insulating material like for example resin. An example is given in Fig. 5f which shows the filling 550a to 550c of the apertures by resin.

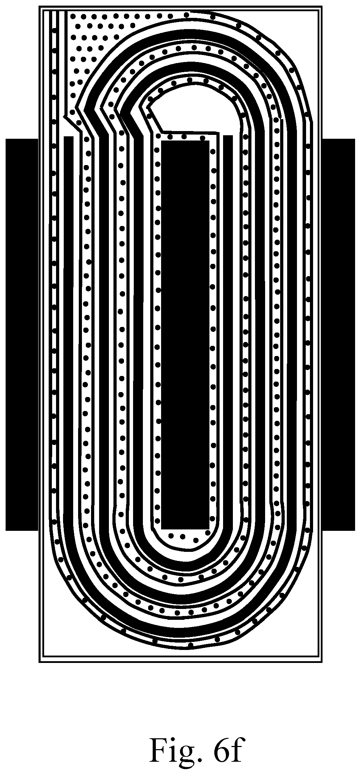

Another example is given in Fig. 6f which shows the filling 650 of the apertures by resin.

At step S126, the soluble prepeg is removed using solvent.

As a result, the plated apertures, the plated via and the vias filled by copper form a conducting pattern that comprises a cooling channel made by the cavities revealed by the removed soluble prepeg and the cooling channel acts also as conducting patterns. According to a particular feature, the following steps are performed:
- laminating the obtained PCB in order to obtain a PCB as shown in Fig. 5g,
- electrically connecting the copper layers are respectively by vias 570 and 571 shown in Fig. 5h and etching the copper layers in order to form an inductive component composed of the conducting patterns.

The Fig.5g shows the PCB obtained at step S126 on the top of which a layer of conventional pre preg material 561 and a copper layer 560 are laminated and on the bottom of which a layer of conventional pre preg material 562 and a copper layer 563 are laminated.

The Fig. 5g shows the PCB obtained at step S126 on the top of which a layer of conventional pre preg material 561 and a copper layer 560 are laminated and on the bottom of which a layer of conventional pre preg material 562 and a copper layer 563 are laminated.

**Fig. 2** represents an example of an architecture of a device for manufacturing a printed circuit board embedding a cooling cavity according to the present invention that may be used in a magnetic component.

The device 20 for manufacturing a printed circuit board embedding a cooling cavity according to the present invention that may be used in a magnetic component has, for example, an architecture based on components connected together by a bus 201 and a processor 200 controlled by a program as disclosed in Fig. 1a or 1b.

The bus 201 links the processor 200 to a read only memory ROM 202, a random access memory RAM 203 and an input output I/O IF interface 205.

The memory 203 contains registers intended to receive variables and the instructions of the program related to the algorithm as disclosed in Fig. 1a or 1b.

The read-only memory, or possibly a Flash memory 202, contains instructions of the programs related to the algorithm as disclosed in Fig. 1a or 1b, when the device 20 is powered on, are loaded to the random access memory 203. Alternatively, the program may also be executed directly from the ROM memory 202.

The control performed by the device 20 may be implemented in software by execution of a set of instructions or program by a programmable computing machine, such as a PC (*Personal Computer*)*,* a DSP (*Digital Signal Processor*) or a microcontroller; or else implemented in hardware by a machine or a dedicated component, such as an FPGA (*Field Programmable Gate Array*) or an ASIC *(Application-Specific Integrated Circuit).*

In other words, the device 20 includes circuitry, or a device including circuitry, causing the device 20 to perform the program related to the algorithm as disclosed in Fig. 1a or 1b.

**Fig. 3** represents an example of a printed circuit board embedding a cooling cavity according to the present invention.

In the example of Fig. 3, a conventional pre preg material 31 is locally replaced by a soluble preg material 32. The conventional pre preg material and the soluble prepreg material are milled in order to provide a channel 33 that is plated with a conductive material like copper in order to provide an electrically conducting pattern. After dissolution of the soluble prepreg, a liquid or a gaz is injected in the channel formed by the dissolved soluble prepreg in order to provide a cooling cavity.

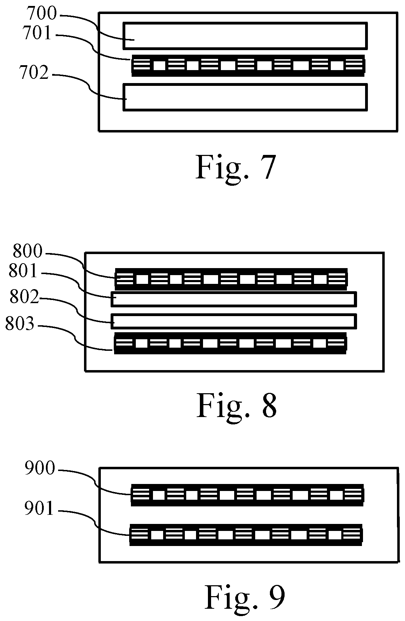

**Fig. 7** represents an example of a magnetic component comprising a printed circuit board embedding a cooling cavity according to the present invention.

In the example of Fig. 7, the printed circuit board embedding a cooling cavity 701 is solely used as a cooler located at the closest of the primary winding's conductors 700 and the secondary winding's conductors 702 and more precisely between the primary and the secondary windings. The cooling cavities are not carrying any of the magnetic device current. However, since the cooling cavities are fully or partially made of a conductive material, eddy currents are generated in the cooling cavities due to the presence of the near magnetic field generated by the magnetic device. The density of vias can be also adjusted to control the pressure drop of a pumping device and customize the effective cooling.

**Fig. 8** represents an example of a magnetic component comprising a printed circuit board embedding a cooling cavity according to the present invention.

In the example of Fig. 8, the printed circuit boards embedding cooling cavities 800 and 803 are solely used as a cooler located at the closest of the primary winding's conductors 801 and the secondary winding's conductors 802 and more precisely at the top of the primary windings 801 and at the bottom of the secondary windings 803. The cooling cavities are not carrying any of the magnetic device current. However, since the cooling cavities are fully or partially made of a conductive material, eddy currents are generated in the cooling cavities due to the presence of the near magnetic field generated by the magnetic device. The density of vias can be also adjusted to control the pressure drop of a pumping device and customize the effective cooling.

**Fig. 9** represents an example of a magnetic component comprising a printed circuit board embedding a cooling cavity according to the present invention.

In the example of Fig. 9, the printed circuit boards embedding cooling cavities 900 and 901 respectively are used as primary and secondary windings.

Naturally, many modifications can be made to the embodiments of the invention described above without departing from the scope of the present invention.

## Claims

1. A method for manufacturing a printed circuit board composed of non soluble conventional preg material part and soluble preg material part, **characterized in that** the method comprises the steps of:
- machining a part of the soluble preg material in order to form a pattern,
- plating the formed pattern,
- filling the platted formed pattern with an electrically insulating material,
- removing the remaining soluble material with a solvent.

2. The method according to claim 1, **characterized in that** the method further comprises the steps, prior removing the remaining soluble material with the solvent, of:
- machining another part of the soluble preg material in order to form another pattern,
- plating the other formed pattern,
- filling the other platted formed pattern with an electrically conductive material.

3. The method according to claim 1 or 2, **characterized in that** the method further comprises the steps of:
- laminating the obtained printed circuit board,
- inserting the laminated obtained printed circuit board in a magnetic component.

4. The method according to claim 3, **characterized in that** the method further comprises the step, executed prior inserting the laminated obtained printed circuit board in the magnetic component, of etching chemically and/or drilling the lamination to make an electrical connection.

5. The method according to any of the claims 1 to 4, **characterized in that** the laminated obtained printed circuit board is inserted between primary winding's conductors and the secondary winding's conductors and secondary windings conductors of a transformer.

6. The method according to any of the claims 1 to 4, **characterized in that** the laminated obtained printed circuit board is inserted at the top of primary windings and at the bottom of secondary windings of a transformer.

7. The method according to any of the claims 1 to 4, **characterized in that** two laminated obtained printed circuit boards are inserted in the magnetic component which is a transformer, one laminated obtained printed circuit board acting as a primary winding and one laminated obtained printed circuit board acting as a secondary winding of the transformer.

8. A system for manufacturing a printed circuit board composed of non soluble conventional preg material part and soluble preg material part, **characterized in that** the system comprises:
- means for machining a part of the soluble preg material in order to form a pattern,
- means for plating the formed pattern,
- means for filling the platted formed pattern with an electrically insulating material,
- means for removing the remaining soluble material with a solvent.
